# EUROPÄISCHE PATENTSCHRIFT

(11) **EP 2 647 052 B1**
(45) Veröffentlichungstag und Bekanntmachung des Hinweises auf die Patenterteilung: **03.06.2015**
(21) Anmeldenummer: 11711943.8
(22) Anmeldetag: 05.04.2011
(51) Int. Cl.: H01L 31/02, H02H 7/20

(54) **PHOTOVOLTAIK-ANLAGE**
PHOTOVOLTAIC INSTALLATION
INSTALLATION PHOTOVOLTAÏQUE

(30) Priorität: 01.12.2010 DE 202010013030 U
(43) Veröffentlichungstag der Anmeldung: 09.10.2013
(73) Patentinhaber: Eulektra GmbH, 46485 Wesel (DE)
(72) Erfinder: HAIN, Siegfried, 46499 Hamminkeln (DE)
(74) Vertreter: Nunnenkamp, Jörg
(86) Internationale Anmeldenummer: PCT/EP2011/055279
(87) Internationale Veröffentlichungsnummer: WO 2012/072277

(56) Entgegenhaltungen:
- WO-A2-2010/078303
- DE-A1-102007 032 605
- US-A1- 2001 023 703

## Beschreibung

Die Erfindung betrifft ein Verfahren zum Betrieb einer Photovoltaik-Anlage, mit mehreren in Reihe hintereinander geschalteten Solarzellenmodulen, deren Spannungsausgänge über jeweils zwischengeschaltete Schaltelemente miteinander und mit einem Spannungswandler verbunden sind, welcher ausgangsseitig an einen Verbraucher angeschlossen ist.

Photovoltaik-Anlagen sind aus der Praxis sowie der DE 10 2005 021 152 B4 bekannt. Durch die Zusammenfassung mehrerer Solarzellenmodule bzw. ihrer Spannungsausgänge über die jeweils zwischengeschalteten Schaltelemente lassen sich am Eingang des Spannungswandlers und folglich ausgangsseitig der sämtlichen Solarzellenmodule relativ hohe Gleichspannungen darstellen, die mehrere 100 V, beispielsweise 720 V, betragen können. So werden heutzutage typischerweise Solarzellenmodule realisiert, die ausgangsseitig beispielhaft eine Gleichspannung von 48 V bei voller Lichtausbeute erzeugen. Werden im beschriebenen Fall 15 solcher Solarzellenmodule in Reihe geschaltet und über die jeweils zwischengeschalteten Schaltelemente miteinander verbunden, so steht ausgangsseitig einer solchen Photovoltaik-Anlage eine Gleichspannung von ca. 720 V zur Verfügung und es wird ein Stromfluss von ca. 4 A bei vollständiger oder nahezu vollständiger Energieausbeute beobachtet.

Derartige Leistungszahlen sind zum Betrieb des Spannungswandlers vorteilhaft, weil dieser die Gleichspannung meistens in eine Netz-Wechselspannung umwandelt. Allerdings treten Probleme dann auf, wenn an oder im Bereich eines Gebäudes mit der solchermaßen ausgerüsteten Photovoltaik-Anlage beispielsweise ein Brand beobachtet wird bzw. die beschriebene Hochspannung abgeschaltet werden muss. Zu diesem Zweck hat man sich in der Praxis bereits mit sogenannten DC-Lasttrennschaltern beholfen, welche den Verbraucher von dem Spannungswandler trennen bzw. zwischen die Solarzellenmodule und den Spannungswandler zwischengeschaltet sind. Solche DC-Lasttrennschalter können allerdings nicht verhindern, dass ausgangsseitig der zusammengeschalteten Solarzellenmodule unverändert die zuvor bereits beispielhaft beschriebene Hochspannung anliegt. Das ist besonders für den Fall problematisch, dass bei etwaigen Löscharbeiten oder Abbrucharbeiten die ausgangsseitig der zusammengeschalteten Solarzellenmodule notwendigen Kabel einzeln oder paarweise frei zugänglich sind bzw. ungeschützt herunterhängen. Jedenfalls können die bisherigen Lösungsansätze unter Berücksichtigung einer spannungssicheren und nicht gesundheitsgefährdenden Auslegung nicht überzeugen.

Die gattungsbildende Lehre nach der US 2001/0023703 A1 arbeitet eingangsseitig eines Spannungswandlers mit einem Schalter, welcher sämtliche Solarzellenmodule vom Spannungswandler trennt. Außerdem werden einzelne Schaltelemente zwischen den Solarzellenmodulen mit zeitlicher Verzögerung vom Spannungswandler respektive untereinander getrennt. Dadurch werden die Schaltelemente zwischen den einzelnen Solarzellenmodulen erst dann geöffnet, wenn kein Strom von den Solarzellenmodulen mehr zum Spannungswandler fließt. Allerdings besteht nach wie vor ausgangsseitig des Spannungswandlers die Gefahr von Spannungsspitzen und Überschlägen, beispielsweise durch Induktivitäten oder Kapazitäten.

Im Rahmen der ebenfalls zum Stand der Technik gehörigen DE 10 2007 032 605 A1 geht es um eine Photovoltaik-Anlage, bei welcher der Stromfluss an mindestens einem Photovoltaikelement gesteuert werden kann. Die einzelnen Photovoltaikelemente können gruppenweise elektrisch voneinander getrennt und wieder verbunden werden. Dazu ist ein Schalter vorgesehen, der sich auch drahtlos steuern lässt. Die zuvor angegebenen Probleme sind jedoch durch die bekannte Lösung nicht maßgeblich beeinflusst worden.

Das gilt schließlich auch für eine Photovoltaik-Anlage, wie sie im Rahmen der WO 2010/078303 A2 näher beschrieben wird. Auch in diesem Fall wird eine Sicherheitsabschaltung vorgesehen, welche die einzelnen den Solarzellenmodulen zugeordneten Schaltelemente öffnet. Dennoch können nach wie vor hohe und zu vermeidende Spannungen auftreten.

Der Erfindung liegt das technische Problem zugrunde, ein derartiges Verfahren zum Betrieb einer Photovoltaik-Anlage so weiter zu entwickeln, dass insbesondere die Spannungssicherheit gesteigert ist bzw. Bedienpersonen zuverlässig vor Überspannungen geschützt werden.

Zur Lösung dieser technischen Problemstellung ist ein gattungsgemäßes Verfahren zum Betrieb einer Photovoltaik-Anlage im Rahmen der Erfindung dadurch gekennzeichnet, dass eine mit wenigstens zwei Schaltern ausgerüstete Sicherheitsschalteinheit vorgesehen ist, welche den Spannungswandler ausgangsseitig vom Verbraucher trennt und zugleich sämtliche oder ausgewählte Schaltelemente öffnet, wobei der eine Schalter als Ausgangsschalter zwischen dem Ausgang des Spannungswandlers und dem Verbraucher angeordnet ist und der andere Schalter als Modulschalter einer Steuerleitung für die Schaltelemente zugeordnet ist sowie die beiden Schalter mit einstellbarer Verzögerung zueinander geöffnet werden.

Im Rahmen der Erfindung findet also ein gleichsam zweifacher Schaltvorgang statt. Zu diesem Zweck ist die Sicherheitsschalteinheit mit wenigstens zwei Schaltern ausgerüstet. Typischerweise finden sich n Schaltelemente bzw. Schalter mit n der Anzahl der Solarzellenmodule. Hierbei geht die Erfindung von der Erkenntnis aus, dass zwischen n Solarzellenmodulen n -1 Schaltelemente bzw. Schalter zwischengeschaltet werden müssen, um diese jeweils miteinander und in Reihe verbinden zu können. Zu diesen n -1 Schaltern bzw. Schaltelementen kommt dann noch ein zusätzlicher Schalter hinzu, welcher für die Trennung des Spannungswandlers vom Verbraucher sorgt.

Die wenigstens zwei Schalter der Sicherheitsschalteinheit werden mit einstellbarer Verzögerung zueinander geöffnet. Dabei handelt es sich bei den beiden Schaltern um einerseits den Ausgangsschalter und andererseits den einen oder mehrere Modulschalter. Der Ausgangsschalter ist zwischen dem Ausgang des Spannungswandlers und dem Verbraucher angeordnet. Dagegen findet sich der Modulschalter bzw. finden sich die jeweiligen Modulschalter zwischen den einzelnen oder ausgewählten Solarzellenmodulen. Im Rahmen der Erfindung ist meistens lediglich ein Modulschalter vorgesehen, welcher einer Steuerleitung für die Schaltelemente zugeordnet ist. Selbstverständlich werden auch Varianten abgedeckt, bei welchen beispielsweise jeweils zwei Solarzellenmodule zusammengefasst sind und sich ein Modulschalter lediglich zwischen diesen Solarzellenmodulpaaren findet.

Um nun die beschriebene einstellbare Verzögerung im Detail zu realisieren, ist der Ausgangsschalter regelmäßig als Trennelement ausgebildet und sorgt dafür, dass bei einer Beaufschlagung der Sicherheitsschalteinheit insgesamt der Verbraucher unmittelbar vom Spannungswandler getrennt wird. Das andere zweite Schaltelement bzw. der zweite Schalter der Sicherheitsschalteinheit bzw. der Modulschalter ist dagegen als Steuerelement ausgeführt. Das Steuerelement sorgt dafür, dass das jeweilige Schaltelement oder ausgewählte Schaltelemente zwischen den Solarzellenmodulen mit der einstellbaren Verzögerung geöffnet werden.

Das heißt, die einstellbare Verzögerung zwischen den beiden Schaltern der Sicherheitsschalteinheit wird im Detail dadurch realisiert, dass eine einstellbare Verzögerung zwischen dem Ausgangsschalter und dem Modulschalter (oder den mehreren Modulschaltern) vorgenommen wird. Dabei hat es sich bewährt, wenn zunächst der Ausgangsschalter für eine Trennung des Verbrauchers vom Spannungswandler sorgt und erst im Anschluss daran der eine Modulschalter respektive die jeweiligen Modulschalter oder die ausgewählten Modulschalter geöffnet werden. Das heißt, die Unterbrechung der Verbindung zwischen den einzelnen Solarzellenmodulen oder den ausgewählten Solarzellenmodulen durch Öffnen der an dieser Stelle vorgesehenen Schaltelemente erfolgt mit einstellbarer Verzögerung im Vergleich zur Trennung des Verbrauchers vom Spannungswandler.

Zu diesem Zweck ist der Modulschalter der Sicherheitsschalteinheit über eine gemeinsame Steuerleitung an das Schaltelement, das jeweilige Schaltelement oder die ausgewählten Schaltelemente angeschlossen. Sobald der Modulschalter mit der einstellbaren Verzögerung gegenüber dem Ausgangsschalter beaufschlagt wird, wird die angesprochene Steuerleitung bestromt und sorgt ihrerseits dafür, dass das Schaltelement oder die jeweiligen Schaltelemente geöffnet werden.

Auf diese Weise wird eine maximale Spannungssicherheit und insbesondere eine Gefährdung von Bedienern durch Hochspannung zuverlässig vermieden. Dazu wird zunächst der Spannungswandler vom Verbraucher getrennt, sodass eine Hauptgefährdung beseitigt ist und etwaige Kapazitäten oder Induktivitäten nicht die Solarzellenmodule als solche beschädigen können. Erst im Anschluss daran - mit der einstellbaren Verzögerung - werden die einzelnen Solarzellenmodule voneinander getrennt bzw. findet die Trennung zwischen ausgewählten Solarzellenmodulen statt. Dazu werden sämtliche oder ausgewählte Schaltelemente geöffnet. Typischerweise liegt die beschriebene Verzögerungszeit im Bereich von unter einer Sekunde bis zu mehreren Sekunden, bleibt im Allgemeinen aber unter zehn Sekunden. Meistens wird sogar mit Verzögerungen von weniger als fünf Sekunden gearbeitet.

Als Folge hiervon beobachtet man lediglich die ausgangsseitig des jeweiligen Solarzellenmoduls anstehende maximale Spannung, die typischerweise im Bereich von 48 V angesiedelt ist und hierauf erfindungsgemäß begrenzt wird. Auch die ausgangsseitigen Ströme bei solchen Solarzellenmodulen bewegen sich bei einem Kurzschluss im Bereich von ca. 4A, erreichen allerdings bei Berührung durch eine Bedienperson lediglich Werte von ca. 48 mA. Folglich kann von den Solarzellenmodulen als solche keine Gesundheitsgefährdung (mehr) ausgehen. Das heißt, im Brandfall oder auch bei Inspektions- oder Baumaßnahmen an einem zugehörigen Gehäuse lassen sich etwaige Gesundheitsgefahren für Bedienpersonen vollständig ausschließen und beherrschen. Hierin sind die wesentlichen Vorteile zu sehen.

Nach weiterer vorteilhafter Ausgestaltung können die beiden Schalter der Sicherheitsschalteinheit, also das Trennelement und das Steuerelement bzw. der Ausgangsschalter und der Modulschalter, in einem gemeinsamen Relais oder einer FET (Feldeffekttransistor)-Baueinheit zusammengefasst werden. Des Weiteren hat sich bewährt, wenn das oder die Schaltelemente ebenfalls als Relais ausgebildet sind. Die Schaltelemente bzw. die an dieser Stelle vorgesehenen Relais werden von dem Modulschalter über die bereits angesprochene gemeinsame Steuerleitung beaufschlagt und angesteuert.

Der Einsatz von Relais bei der Realisierung des Ausgangsschalters wie auch des einen bzw. der mehreren Modulschalter und auch der Schaltelemente hat den Vorteil, dass sich die in diesem Zusammenhang oftmals anstehenden hohen elektrischen Leistungen problemlos schalten lassen und Relais darüber hinaus mit einer hohen Überlastbarkeit ausgerüstet sind. Außerdem werden geringe Kontaktübergangswiderstände bei gleichzeitig geringer Kapazität der Schaltstrecke beobachtet, sodass die Solarzellenmodule im Hinblick auf etwaige Störspannungen durch Induktivitäten optimal geschützt sind. Ganz abgesehen davon bauen Relais robust und sind besonders unempfindlich gegenüber Überspannungen. Gleichwohl können an dieser Stelle natürlich auch Halbleiterschalter zum Einsatz kommen, beispielsweise solche auf FET-Basis.

Die Sicherheitsschalteinheit als solche kann manuell und/oder sensorisch beaufschlagt werden. Bei einer manuellen Beaufschlagung wird man typischerweise einen Schaltknopf oder Schalthebel bzw. einen Schaltknebel betätigen. Alternativ oder zusätzlich ist auch eine sensorische Beaufschlagung der Sicherheitsschalteinheit denkbar und wird im Rahmen der Erfindung umfasst. In diesem Fall ist meistens ein Lichtsensor vorgesehen, welcher bei einer bestimmten und unterschrittenen Lichtstärke die Sicherheitsschalteinheit betätigt. Das heißt, sobald es beispielsweise Nacht wird und die Solarzellenmodule ohnehin keinen Strom mehr erzeugen, wird über den Lichtsensor die Sicherheitsschalteinheit beaufschlagt und erfahren folglich die einzelnen Solarzellenmodule die beschriebene Trennung untereinander. Außerdem wird der Verbraucher von dem Spannungswandler getrennt.

Anstelle oder ergänzend zu dem Lichtsensor kann auch ein Brandmelder bzw. ein Hitze- und/oder Feuersensor für die beschriebene sensorische Beaufschlagung der Sicherheitsschalteinheit sorgen. Dieser Brandmelder bzw. ein entsprechend ausgelegter Sensor sorgt dafür, dass im Brandfall die Sicherheitsschalteinheit getätigt wird und die Solarzellenmodule untereinander getrennt werden. Sobald in diesem Fall also die Feuerwehr zum Einsatz kommt, liegen die zuvor bereits beschriebenen Spannungen im Bereich von 48 V und nicht mehr an den einzelnen Solarzellenmodulen an und bewegt sich der an einen menschlichen Körper abgegebene Strom im ungefährlichen Bereich.

Schließlich kann auch noch eine Steuereinheit vorgesehen werden, welche je nach vom Solarzellenmodul erzeugter Ausgangsleistung bzw. in Abhängigkeit von der erzeugten Ausgangsspannung die einzelnen Schaltelemente ansteuert. Das geschieht in der Regel bei betätigter Sicherheitsschalteinheit. Das heißt, mit Hilfe der Steuereinheit kann zunächst geprüft werden, welches der zu der Photovoltaik-Anlage zusammengefassten Solarzellenmodule überhaupt eine nennenswerte Ausgangsleistung erzeugt und abgibt. Je nachdem, welches Ergebnis diese Messung liefert, können dann bedarfsweise nicht sämtliche sondern lediglich ausgewählte Modulschalter geöffnet werden. Auch in diesem Fall wird man so vorgehen, dass die Steuereinheit einzelne Solarzellenmodule nur dann zusammenfasst und keine Trennung bewirkt, wenn die kumulierte Ausgangsleistung in jedem Fall eine Gesundheitsgefahr für den jeweiligen Bediener ausschließt. Im Regelfall und aus Gründen einer optimalen Sicherheit wird jedoch meistens so vorgegangen, dass sämtliche vorhandenen Schaltelemente bei betätigter Sicherheitsschalteinheit geöffnet werden.

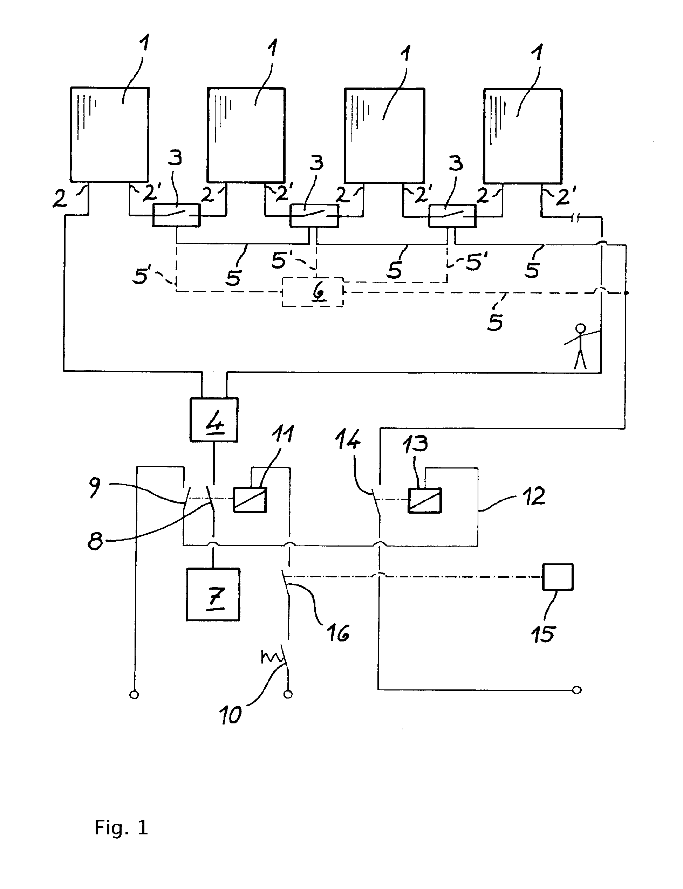

Im Folgenden wird die Erfindung anhand einer lediglich ein Ausführungsbeispiel darstellenden Zeichnung näher erläutert. Die einzige Figur zeigt eine erfindungsgemäße Photovoltaik-Anlage in schematischem Aufbau.

In der Figur ist eine Photovoltaik-Anlage dargestellt, die mit mehreren Solarzellenmodulen 1 ausgerüstet ist. Nach dem Ausführungsbeispiel sind vier Solarzellenmodule 1 realisiert, was selbstverständlich nur beispielhaft und nicht einschränkend zu verstehen ist. Die einzelnen Solarzellenmodule 1 sind in Reihe hintereinander geschaltet. Dazu sind jeweilige Spannungsausgänge 2, 2' der einzelnen Solarzellenmodule 1 über jeweils zwischengeschaltete Schaltelemente 3 miteinander und mit einem Spannungswandler 4 verbunden. Bei dem Spannungswandler 4 handelt es sich nicht einschränkend um einen Wechselrichter, welcher die ausgangsseitig von den sämtlichen zusammengeschalteten Solarzellenmodulen 1 zur Verfügung gestellte Gleichspannung in eine (Netz-)Wechselspannung wandelt.

Zu diesem Zweck ist der jeweilige Ausgang 2 eines Solarzellenmodules 1 über das zwischengeschaltete Schaltelement 3 mit einem Eingang bzw. weiteren Ausgang 2' eines benachbarten Solarzellenmodules 1 verbunden und so weiter. Die einzelnen zwischengeschalteten Schaltelemente 3 sind als Relais 3 ausgebildet und über eine gemeinsame Steuerleitung 5 miteinander verbunden bzw. können mit Hilfe eines über die Steuerleitung 5 anliegenden und zur Verfügung gestellten Steuerstromes gleichzeitig fernbetätigt werden.

Eine Alternativbetätigung ist gestrichelt in der Darstellung gezeigt. In diesem Fall ist eine Steuereinheit 6 vorgesehen, deren Eingang an die Steuerleitung 5 angeschlossen ist und die jeweils mit ausgangsseitigen einzelnen Steuerleitungen 5' verbunden ist. Jede Steuerleitung 5' beaufschlagt ein zugehöriges Schaltelement 3. Auf diese Weise können die Schaltelemente 3 einzeln mit Hilfe der Steuereinheit 6 betätigt werden, wohingegen im Regelfall die sämtlichen Schaltelemente 3 über die gemeinsame Steuerleitung 5 zusammen eine Beaufschlagung erfahren. Ausgangsseitig des Spannungswandlers 4 ist an diesen ein Verbraucher 7 angeschlossen. Hierbei kann es sich im einfachsten Fall um einen Netzanschluss handeln, in welchen die mit Hilfe der Photovoltaik-Anlage erzeugte elektrische Energie als Wechselspannung eingespeist wird.

Von besonderer erfindungsgemäßer Bedeutung ist nun eine zusätzlich vorgesehene Sicherheitsschalteinheit 8, 9, welche den Spannungswandler 4 ausgangsseitig vom Verbraucher 7 trennt und zugleich sämtliche oder ausgewählte Schaltelemente 3 öffnet. Das heißt, die Sicherheitsschalteinheit 8, 9 ist ausgangsseitig an den Spannungswandler 4 angeschlossen und sorgt zunächst einmal dafür, dass der Spannungswandler 4 bei einer Betätigung der Sicherheitsschalteinheit 8, 9 vom Verbraucher 7 getrennt wird. Darüber hinaus sorgt die Sicherheitsschalteinheit 8, 9 dafür, dass sämtliche oder ausgewählte Schaltelemente 3 zwischen den einzelnen Solarzellenmodulen 1 geöffnet werden.

Zu diesem Zweck setzt sich die Sicherheitsschalteinheit 8, 9 aus wenigstens zwei Schaltern 8, 9 zusammen. Die beiden Schalter 8, 9 können mit einstellbarer Verzögerung zueinander geöffnet werden. Tatsächlich ist der eine Schalter 8 als Ausgangsschalter 8 zwischen dem Ausgang des Spannungswandlers 4 und dem Verbraucher 7 angeordnet. Dagegen handelt es sich bei dem anderen Schalter 9 um einen Modulschalter 9, welcher in die Steuerleitung 5 eingeschleift ist bzw. dieser zugeordnet ist. Ist der Modulschalter 9 geschlossen, so wird die Steuerleitung 5 zur Beaufschlagung der einzelnen Schaltelemente 3 zwischen den Solarzellenmodulen 1 bestromt und werden folglich die Schaltelemente 3 nicht geöffnet und behalten ihren üblicherweise eingenommenen geschlossenen Zustand bei. Die Solarzellenmodule 1 sind dann unverändert in Reihe geschaltet miteinander verbunden. Wenn jedoch der Modulschalter 9 geöffnet wird, so erfährt die Steuerleitung 5 keine Bestromung und werden als Folge hiervon die einzelnen Schaltelemente 3 zwischen den Solarzellenmodulen 1 geöffnet. Deren Reihenschaltung ist unterbrochen.

Die Betätigung des Modulschalters 9 erfolgt mit einstellbarer Verzögerung nach Betätigung des Ausgangsschalters 8. Zu diesem Zweck sind die beiden Schalter 8, 9 in einem gemeinsamen Relais 8, 9, 11 zusammengefasst. Dieses Relais 8, 9, 11 ist mit einer Einstellvorrichtung ausgerüstet, um die beschriebene Verzögerungszeit zwischen dem Öffnen und/oder Schließen des Ausgangsschalters 8 und demjenigen des Modulschalters 9 einzustellen. Typischerweise wird hier mit Verzögerungszeiten von weniger als zehn Sekunden und meistens sogar von weniger als fünf Sekunden gearbeitet.

Die Sicherheitsschalteinheit 8, 9 ist mit einem manuellen Betätigungselement 10 ausgerüstet. Dieses manuelle Betätigungselement 10 korrespondiert in der Regel zu einem geschlossenen Stromkreis für eine Spule 11 des Relais 8, 9, 11. Als Folge hiervon wird die Spule 11 bestromt und der Ausgangsschalter 8 sowie der Modulschalter 9 sind geschlossen. Gleiches gilt für die einzelnen Schaltelemente 3 zwischen den Solarzellenmodulen 1. Dies ist der übliche Funktionszustand, wenn die Solarzellenmodule 1 in Reihe geschaltet sind und Strom an den Spannungswandler 4 zur Versorgung des Verbrauchers 7 liefern.

Wird nun beispielsweise das manuelle Betätigungselement 10 geöffnet, so trennt der Ausgangsschalter 8 unmittelbar den Spannungswandler 4 von dem Verbraucher 7. Mit einstellbarer Zeitverzögerung danach wird der Modulschalter 9 ebenfalls geöffnet. Dies hat zur Folge, dass der Steuerstromkreis 12 keine Bestromung mehr erfährt und folglich das zugehörige Relais 13, 14 nicht mehr bestromt. Der zu dem Relais 13, 14 gehörige Schalter 14 in der Steuerleitung 5 wird geöffnet. Hieraus resultiert, dass die einzelnen Schaltelemente 3 zwischen den Solarzellenmodulen 1 - meistens synchron - ebenfalls geöffnet werden. Das heißt, die einzelnen Schaltelemente 3 zwischen den Solarzellenmodulen 1 werden synchron geöffnet, sobald auch der Modulschalter 9 mit der einstellbaren Verzögerung gegenüber dem Ausgangsschalter 8 eine Öffnung erfahren hat.

Der Modulschalter 9 sorgt also für eine Fernbetätigung der Steuerleitung 5 über das Relais 13, 14 in dem dem Modulschalter 9 zugeordneten Steuerstromkreis 12. Im üblichen Betrieb ist der Modulschalter 9 geschlossen und wird der Steuerstromkreis 12 bestromt. Dadurch ist ebenfalls der Schalter 14 geschlossen und wird die Steuerleitung 5 bestromt, welche ihrerseits dafür sorgt, dass die einzelnen Schaltelemente 3 zwischen den Solarzellenmodulen 1 geschlossen sind.

Sobald jedoch das manuelle Betätigungselement 10 - beispielsweise bei einem Brand - geöffnet worden ist, werden die einzelnen Solarzellenmodule 1 durch dann ebenfalls geöffneten Schaltelemente 3 voneinander getrennt. Damit steht ausgangsseitig der einzelnen Solarzellenmodule lediglich eine Spannung von maximal 48 V im Beispielfall an.

Eine in der einzigen Figur lediglich angedeutete Bedienperson kann folglich problemlos einen Ausgang 2 bzw. 2' des Solarzellenmoduls 1 berühren. Da der menschliche Körper typischerweise einen Widerstand von ca. 1 kΩ aufweist, resultiert bei der beschriebenen anliegenden Spannung von 48 V im Beispielfall hieraus ein Strom vom 48 mA. Derartige Werte sind auf jeden Fall ungefährlich und nicht gesundheitsschädigend.

Man erkennt schließlich noch einen Lichtsensor 15, welcher bei einer bestimmten Lichtstärke die Sicherheitsschalteinheit 8, 9 betätigt. Zu diesem Zweck beaufschlagt der Lichtsensor 15 einen Schalter 16, welcher in Reihe zu dem manuellen Betätigungselement 10 im Steuerstromkreis für die Spule 11 des Relais 8, 9, 11 geschaltet ist.

Da im Regelfall das manuelle Betätigungselement 10 geschlossen ist und Strom durch Lichteinfall produziert wird, sorgt der Lichtsensor 15 dafür, dass dann auch der Schalter 16 geschlossen ist, so dass die Stromproduktion wie beschrieben erfolgen kann. Sobald jedoch die Sonne untergegangen ist oder während der Nacht sorgt der Lichtsensor 15 dafür, dass der Schalter 16 aus Sicherheitsgründen geöffnet wird. Als Folge hiervon erfahren dann zunächst der Ausgangsschalter 8 und nach der einstellbaren Verzögerungszeit der Modulschalter 9 eine Öffnung mit den bereits beschriebenen Folgen.

Es versteht sich, dass der Lichtsensor 15 nicht auf jede Änderung der Lichtintensität reagiert, beispielsweise infolge eines Gewitters, einer Abschattung durch Wolken etc.. Aus diesem Grund wird man den Lichtsensor 15 vorteilhaft mit einer Zeitschaltuhr kombinieren bzw. setzt von vornherein eine Zeitschaltuhr als Lichtsensor 15 ein. Diese Zeitschaltuhr mag in Abhängigkeit von der geografischen Breite des Aufstellungsortes und der Jahreszeit eingespeicherte Werte für den Sonnenaufgang und Sonnenuntergang aufweisen bzw. beinhalten. Selbstverständlich können die fraglichen Werte auch eingespeist werden. In Abhängigkeit hiervon sorgt dann der Lichtsensor 15 dafür, dass die erfindungsgemäße Photovoltaik-Anlage während der gesamten Sonnenscheindauer eingeschaltet wird und lediglich nach Sonnenuntergang und aus Sicherheitsgründen eine Abschaltung erfährt.

## Patentansprüche

1. Verfahren zum Betrieb einer Photovoltaik-Anlage mit mehreren in Reihe hintereinander geschalteten Solarzellenmodulen (1), deren Spannungsausgänge (2, 2') über jeweils zwischengeschaltete Schaltelemente (3) miteinander und mit einem Spannungswandler (4) verbunden sind, welcher ausgangsseitig an einen Verbraucher (7) angeschlossen ist, **dadurch gekennzeichnet, dass**
- eine mit wenigstens zwei Schaltern (8, 9) ausgerüstete Sicherheitsschalteinheit (8, 9) vorgesehen ist, welche den Spannungswandler (4) ausgangsseitig vom Verbraucher (7) trennt und zugleich sämtliche oder ausgewählte Schaltelemente (3) öffnet, wobei
- der eine Schalter (8) als Ausgangsschalter (8) zwischen dem Ausgang des Spannungswandlers (4) und dem Verbraucher (7) angeordnet ist und
- der andere Schalter (9) als Modulschalter (9) einer Steuerleitung (5) für die Schaltelemente (3) zugeordnet ist sowie
- die beiden Schalter (8, 9) mit einstellbarer Verzögerung zueinander geöffnet werden.

2. Verfahren nach Anspruch 1, **dadurch gekennzeichnet, dass** die beiden Schalter (8, 9) zu einem Relais (8, 9, 11) zusammengefasst sind.

3. Verfahren nach Anspruch 1 oder 2, **dadurch gekennzeichnet, dass** die Sicherheitsschalteinheit (8, 9) manuell und/oder sensorisch beaufschlagt wird.

4. Verfahren nach Anspruch 3, **dadurch gekennzeichnet, dass** der Sicherheitsschalteinheit (8, 9) ein manuelles Betätigungselement (10) zugeordnet ist.

5. Verfahren nach einem der Ansprüche 1 bis 4, **dadurch gekennzeichnet, dass** zusätzlich ein Lichtsensor (15) und/oder ein Brandmelder vorgesehen sind, welcher bei einer bestimmten Lichtstärke und/oder Temperatur die Sicherheitsschalteinheit (8, 9) betätigt.

6. Verfahren nach einem der Ansprüche 1 bis 5, **dadurch gekennzeichnet, dass** eine Steuereinheit (6) vorgesehen ist, welche je nach vom jeweiligen Solarzellenmodul (1) erzeugter Ausgangsleistung die einzelnen Schaltelemente (3) bei betätigter Sicherheitsschalteinheit (8, 9) öffnet oder im geschlossenem Zustand belässt.

## Claims

1. A method for the operation of a photovoltaic plant with a plurality of solar cell modules (1) connected in series one behind another, whose voltage outputs (2, 2') are connected with one another, in each case via interposed switching elements (3), and with a voltage transformer (4), the output side of which is connected to a load (7),
**characterised in that**,
- a safety switching unit (8, 9) fitted with at least two switches (8, 9) is provided, which separates the voltage transformer (4) on its output side from the load (7), and at the same time opens all or selected switching elements (3), wherein
- the one switch (8) is arranged as an output switch (8) between the output of the voltage transformer (4) and the load (7), and
- the other switch (9) is assigned as a module switch (9) of a control line (5) for the switching elements (3), and
- the two switches (8, 9) are opened with an adjustable delay relative to one another.

2. The method in accordance with Claim 1,
**characterised in that**,
the two switches (8, 9) are combined into one relay (8, 9, 11).

3. The method in accordance with Claim 1 or 2,
**characterised in that**,
the safety switching unit (8, 9) is operated manually and/or via a sensor.

4. The method in accordance with Claim 3,
**characterised in that**,
a manual actuation element (10) is assigned to the safety switching unit (8, 9).

5. The method in accordance with one of the Claims 1 to 4,
**characterised in that**,
in addition a light sensor (15) and/or a fire detector is provided, which at a particular light intensity and/or temperature actuates the safety switching unit (8, 9).

6. The method in accordance with one of the Claims 1 to 5,
**characterised in that**,
a control unit (6) is provided, which, depending upon the output power generated by the respective solar cell module (1), opens the individual switching elements (3) when the safety switching unit (8, 9) is actuated, or leaves them in the closed state.

## Revendications

1. Procédé pour l'exploitation d'une installation photovoltaïque avec plusieurs modules de piles solaires (1) connectés en série les uns derrière les autres, dont les sorties de tension (2, 2') sont reliées entre elles et à un transformateur de tension (4) via des éléments de commutation (3) respectivement interconnectés, lequel transformateur est relié côté sortie à un consommateur (7),
**caractérisé en ce que**
- l'on prévoit une unité de commutation de sécurité (8, 9) équipée d'au moins deux commutateurs (8, 9), laquelle sépare le transformateur de tension (4), côté sortie, du consommateur (7) et ouvre simultanément l'ensemble des éléments de commutation ou des éléments de commutation (3) sélectionnés, dans lequel
- l'un des commutateurs (8) est disposé, en tant que commutateur de sortie (8), entre la sortie du transformateur de tension (4) et le consommateur (7), et
- l'autre commutateur (9) étant associé, en tant que commutateur de module (9), à une ligne pilote (5) pour les éléments de commutation (3), et
- les deux commutateurs (8, 9) étant ouverts avec un retard l'un par rapport à l'autre pouvant être réglé.

2. Procédé selon la revendication 1, **caractérisé en ce que** les deux commutateurs (8, 9) sont assemblés pour donner un relais (8, 9, 11).

3. Procédé selon la revendication 1 ou 2, **caractérisé en ce que** l'unité de commutation de sécurité (8, 9) est sollicités manuellement et/ou de manière sensorielle.

4. Procédé selon la revendication 3, **caractérisé en ce qu'**un élément d'actionnement manuel (10) est associé à l'unité de commutation de sécurité (8, 9).

5. Procédé selon l'une des revendications 1 à 4, **caractérisé en ce que** l'on prévoit additionnellement un capteur de lumière (15) et/ou un détecteur d'incendie lequel, en cas d'une intensité lumineuse déterminée et/ou d'une température déterminée, actionne l'unité de commutation de sécurité (8, 9).

6. Procédé selon l'une des revendications 1 à 5, **caractérisé en ce que** l'on prévoit une unité de commande (6) laquelle, en fonction de la puissance de sortie générée par le module de piles solaires (1) respectif, ouvre les éléments de commutation (3) individuels en cas d'unité de commutation de sécurité (8, 9) actionnée ou les laisse à l'état fermé.
